# EUROPEAN PATENT APPLICATION

(11) **EP 4 783 057 A1**
(43) Date of publication of application: **29.07.2026**
(21) Application number: 25305102.3
(22) Date of filing: 27.01.2025
(51) Int. Cl.: G06F 30/12, G06T 19/20

(54) **A COMPUTER-IMPLEMENTED METHOD FOR UPDATING AN EXPLODED PATH WITHIN A 3D SCENE**

(71) Applicant: Dassault Systèmes, 78140 Vélizy-Villacoublay (FR)
(72) Inventor: PERRONE, Iolanda, 78140 Vélizy-Villacoublay (FR); DELFINO, Christophe, 78140 Vélizy-Villacoublay (FR)
(74) Representative: Plasseraud IP

(57) **Abstract**

The invention relates to a method for updating an exploded path (25) within a 3D scene (11), comprising:
- displaying a 3D scene (11) provided with a three-axis system (15) and including an exploded path (25) extending from a starting point (SP) to a finishing point (FP), the exploded path (25) being a connected series of at least three line segments (25A, 25B, 25C, 25D) each aligned with one of the axes (X, Y, Z) of the three-axis system (15) according to a periodic direction pattern;
and, upon instruction to apply a translation to a line segment (25C):
- applying the translation to this line segment (25C) and to the following or preceding line segment (25B, 25D) to preserve the periodic direction pattern, and, if necessary,
- adding a linking line segment to relink the exploded path (25) to the starting or finishing point (SP, FP).

## Description

The field of the invention relates to the update of an exploded path within a 3D scene, for instance in an assembly diagram.

In the field of computer-aided design (CAD), exploded paths are commonly used to schematically represent the path of an object - or more precisely, the corresponding 3D object model - from an initial position to a final position. Exploded paths can also be used in assembly diagrams to schematically link together two industrial components - or more precisely, the corresponding 3D industrial component models - intended to be assembled together. In such a case, the exploded paths provide essential guidance in assembly instructions and enhance the clarity of technical documentation by visually depicting the relative positions of industrial components in an exploded view.

Conventional methods for creating exploded paths in CAD software or applications rely on the use of polylines, i.e. connected series of line segments. However, polylines are generally fixed in a virtual 3D space, making them difficult to update when the position of a 3D industrial component model changes. In many cases, the user must completely redraw the polyline to reflect the new configuration, which is time-consuming and inefficient.

A further limitation of the existing solutions is the lack of predictability when updating an exploded path. Adjustments to the exploded path often result in abrupt or sweeping changes that disrupt its overall shape. Users may struggle to maintain control over the design process, as modifications can lead to unpredictable alterations across the entire exploded path. This unpredictability increases the effort required to achieve the desired outcome, particularly when precise customization of the exploded path is needed to accommodate specific design constraints or visual clarity.

There is therefore a need for a solution providing greater predictability and flexibility in editing exploded paths, allowing users to intuitively modify them to navigate around obstacles in a virtual 3D space. This is particularly important for avoiding visual overlaps with 3D industrial component models or other exploded paths, which can compromise the readability of assembly diagrams.

The present invention seeks to improve the situation.

To this end, the Applicant proposes a computer-implemented method for updating an exploded path within a 3D scene, comprising the following operations:
a) displaying a 3D scene, the 3D scene being a virtual 3D space provided with a three-axis system and containing at least one 3D model, a fixed starting point and a fixed finishing point, the at least one 3D model being augmented with an exploded path extending from the fixed starting point to the fixed finishing point, the exploded path being a connected series of at least three line segments each aligned with one of the axes of the three-axis system according to a periodic direction pattern;
b) attaching a respective handle to one or more line segments of the connected series of at least three line segments, except the first and last line segments, each handle enabling the line segment to which it is attached to translate along a first and a second direction only, the first direction corresponding to the direction of the preceding line segment, the second direction corresponding to the direction of the following line segment.

The computer-implemented method further comprises, upon instruction to apply a given translation to a given line segment to which a given handle is attached:
c) applying the given translation to both the given line segment and either the following line segment when the direction of the given translation is the first direction, or the preceding line segment when the direction of the given translation is the second direction, thereby preserving the periodic direction pattern; and, if the exploded path no longer extends from the fixed starting point or to the fixed finishing point as a result of operation c),
d) adding to the connected series of at least three line segments a linking line segment aligned with the direction of the given translation to relink the exploded path to the fixed starting point or the fixed finishing point.

This computer-implemented method allows for both precise customization and dynamic adaptation of exploded paths. As a result the usability and efficiency of CAD software or applications is improved, particularly in the context of creating and updating assembly diagrams where exploded paths must navigate a complex 3D scene cluttered with 3D industrial component models. This flexibility ensures that the exploded paths remain comprehensible, even in scenarios involving intricate assemblies or densely populated 3D scenes. Moreover, any updates to an exploded path is predictable, thereby ensuring that users maintain control over the design process.

According to one or more embodiments, in operation b), a respective handle is attached to each line segment of the connected series of at least three line segments, except the first and last line segments.

According to one or more embodiments, operation d) includes attaching a handle to the line segment that, among the preceding line segment and the following line segment, is connected to the linking line segment.

According to one or embodiments, in operation b), attaching a respective handle to one or more line segments of the connected series of at least three line segments results in the display of a respective graphical icon next to or on the one or more line segments.

According to one or embodiments, the instruction to apply the given translation to the given line segment to which the given handle is attached is detected based on data received from an input device.

The direction of the given translation can be determined based on the data.

Alternatively, in operation a), the 3D scene is projected onto a viewing plane, and the direction of the given translation is determined as follows:
computing a first angle between the orthogonal projections onto the viewing plane of the direction of the given line segment and the first direction,
computing a second angle between the orthogonal projections onto the viewing plane of the direction of the given line segment and the second direction, and
selecting the first direction if the first angle is closer to a right angle than the second angle, or the second direction if the second angle is closer to a right angle than the first angle.

Advantageously, the connected series of at least three line segments is a connected series of at least four line segments.

According to one or embodiments, the computer-implemented method further comprises, upon instruction to delete the first line segment or the last line segment from the connected series of at least four line segments:
e) generating an adjustment translation whose direction and magnitude are respectively the direction and the length of the line segment to be deleted;
f) deleting the line segment to be deleted;
g) identifying, within the connected series of at least four line segments, a line segment aligned with the direction of the deleted line segment; and
h) applying the adjustment translation to all the line segments of the connected series of at least four line segments that either precede the identified line segment when the deleted line segment was the first line segment, or follow the identified line segment when the deleted line segment was the last line segment to relink the exploded path to the fixed starting point or the fixed finishing point.

According to one or embodiments, each line segment of the connected series of at least three line segments being bounded by two endpoints, the application of any translation to any consecutive line segments of the connected series of at least three line segments is performed by applying the translation to each endpoint of at least one line segment of the consecutive line segments.

According to one or embodiments, each line segment of the connected series of at least three line segments is a dashed line, a dotted line or a dash-dotted line.

According to one or embodiments, the 3D scene is an assembly diagram, the at least one 3D model includes a first 3D industrial component model and a second 3D industrial component model positioned at the fixed starting point and the fixed finishing point, respectively, the first and second 3D industrial component models respectively corresponding to first and second real industrial components intended to be assembled together.

The Applicant also proposes a computer program comprising instructions for implementing the above-mentioned computer-implemented method when the instructions are executed by at least one processor.

The Applicant also proposes a computer-readable storage medium having stored thereon the above-mentioned computer program.

Finally, the Applicant further proposes a device for updating an exploded path within a 3D scene, comprising:
- a display unit configured to display a 3D scene, the 3D scene being a virtual 3D space provided with a three-axis system and containing at least one 3D model, a fixed starting point and a fixed finishing point, the at least one 3D model being augmented with an exploded path extending from the fixed starting point to the fixed finishing point, the exploded path being a connected series of at least three line segments each aligned with one of the axes of the three-axis system according to a periodic direction pattern;
- an exploded path management unit configured to
   - attach a handle to any line segment of the connected series of at least three line segments, except the first and last line segments, the handle enabling the line segment to which it is attached to translate along a first and a second direction only, the first direction corresponding to the direction of the preceding line segment, the second direction corresponding to the direction of the following line segment,
   - apply to any line segment to which a handle is attached any translation whose direction is the first or second direction, and
   - add to the connected series of at least three line segments a line segment aligned with one of the axes of the three-axis system; and
- a processor configured, upon instruction to apply a given translation to a given line segment to which a given handle is attached, to cause the exploded path management unit to
   - apply the given translation to both the given line segment and either the following line segment when the direction of the given translation is the first direction, or the preceding line segment when the direction of the given translation is the second direction, thereby preserving the periodic direction pattern, and, if the exploded path no longer extends from the fixed starting point or to the fixed finishing point as a result of the application of the given translation,
   - add a linking line segment aligned with the direction of the given translation to relink the exploded path to the fixed starting point or the fixed finishing point.

Other features and advantages of the invention will become apparent from the following description provided for indicative and non-limiting purposes, with reference to the accompanying drawings, wherein:
- Figure 1 illustrates a device for updating an exploded path within a 3D scene according to the invention,
- Figure 2 illustrates a computer-implemented method for updating an exploded path within a 3D scene according to the invention,
- Figure 3 illustrates a 3D scene including 3D models augmented with an exploded path,
- Figure 4A illustrates operations of translating line segments of the computer-implemented method of Figure 2 applied to the exploded path of Figure 3,
- Figure 4B illustrates an operation of adding a line segment of the computer-implemented method of Figure 2 applied to the exploded path of Figure 4A,
- Figure 5 illustrates other operations of translating line segments of the computer-implemented method of Figure 2 applied to the exploded path of Figure 3,
- Figure 6 illustrates optional operations of the computer-implemented method for deleting a line segment from an exploded path,
- Figure 7A illustrates an operation of deleting a line segment of the optional operations of Figure 6 applied to the exploded path of Figure 3, and
- Figure 7B illustrates an operation of translating line segments of the optional operations of Figure 6 applied to the exploded path of Figure 7A.

The drawings and the following description are comprised for the most part of positive and well-defined features. As a result, they are not only useful in understanding the invention, but they can also be used to contribute to its definition, should the need arise.

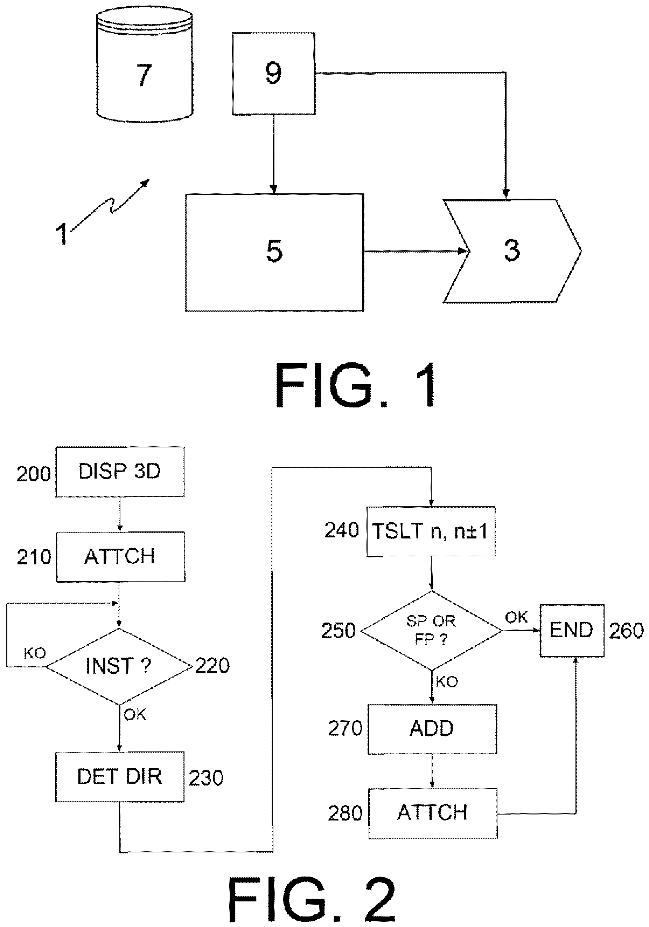

Figure 1 illustrates a device 1 for updating an exploded path within a 3D scene.

The device 1 is all or part of a computing device or system equipped with a human-machine interface (HMI). The human-machine interface enables a user to interact with the device 1, particularly to open and use computer-aided design (CAD) software or application.

The opening of such CAD software or application is accompanied by or triggers the display of an associated graphical user interface (GUI). The CAD software or application can be native and thus directly accessible on the device 1. Alternatively, the CAD software or application is downloadable from an application store. Alternatively, the CAD software or application is accessible over a wide area network (WAN) such as the Internet, or a private network such as an intranet.

The human-machine interface includes one or more input devices configured to provide data and instructions to the device 1. The human-machine interface allows the user to control the device 1, especially for opening the CAD software or application and using it through the graphical user interface. Examples of input devices include a keyboard or a pointing device.

A pointing device enables the user to input spatial data to the device 1. The reception of spatial data by the device 1 results in the movement of a cursor - or pointer - on the graphical user interface. The pointing device can be used to perform various functions, accessible directly on the graphical user interface through associated graphical icons, using gestures such as point-and-click or drag-and-drop. The pointing device is for instance a computer mouse or a touchpad.

A CAD software or application enables the user to generate or manipulate a 3D scene.

A 3D scene is a virtual 3D space - or environment - containing one or more 3D models.

The virtual 3D space is characterized by scene parameters such as lighting, shading, texturing, and the viewpoint, which affect how the 3D models are rendered. The 3D models are characterized by model parameters such as position, size, and geometry.

The virtual 3D space is provided with a three-axis system. The three-axis system includes three axes - commonly denoted X, Y and Z - each defining a respective direction. Typically, the three axes are orthogonal.

The graphical user interface offers a variety of functionalities, such as a functionality for animating the 3D scene, i.e. for rendering the 3D scene into a sequence of 2D frames or images compiled into a final video.

The invention relates to a feature of the device 1 for updating an exploded path within a 3D scene.

Such a feature finds application in a CAD software or application, specifically for generating or manipulating a 3D scene including at least one 3D model augmented with an exploded path.

An exploded path is a connected series of at least three line segments. Equivalently, the exploded path is defined by a sequence of at least four vertices, where any two consecutive vertices are connected by a line segment. The first vertex and the last vertex are the endpoints of the exploded path.

Each line segment is bounded by two endpoints which are consecutive vertices, where any two consecutive line segments are connected to each other via their unique common endpoint. The first line segment is the line segment whose one of the two endpoints is the first vertex, and the last line segment is the line segment whose one of the two endpoints is the last vertex.

Each line segment of the exploded path generally takes the form of a dashed line, a dotted line or a dash-dotted line.

The exploded path can be referred to as a polygonal chain or a polyline.

The feature applies in a context in which the exploded path exhibits two characteristics detailed hereinafter.

According to a first characteristic, the exploded path extends from a fixed starting point to a fixed finishing point within the virtual 3D space. The fixed starting point and the fixed finishing point are *fixed* in that they do not belong to the exploded path; the fixed starting point and the fixed finishing point are anchored in the virtual 3D space. The first vertex and the last vertex therefore coincide with the fixed starting point and the fixed finishing point, respectively. In other words, the exploded path is linked to the fixed starting point and the fixed finishing point via the first line segment and the last line segment, respectively.

According to a second characteristic, each line segment of the exploded path is aligned with one of the axes of the three-axis system, and the exploded path follows a periodic direction pattern. In other words, the sequence of directions of the line segments is a periodic sequence. The period, i.e. the number of repeated directions, is typically equal to three.

In this regard, one of the challenges of updating the exploded path is to keep the first and second characteristics. The positions of the endpoints of the exploded path, i.e. the first and last vertices, remain at the fixed starting point and fixed finishing point; and the periodic direction pattern is preserved. In other words, the first and second characteristics are invariants of the update.

The 3D scene is for instance an assembly diagram intended to be included in technical documentation.

In such a case, the 3D scene is an exploded view, and the virtual 3D space contains several 3D industrial component models. The exploded path links together two 3D industrial component models corresponding to real industrial components to be assembled together. The 3D scene can include a plurality of exploded paths, each linking together two 3D industrial component models. The industrial components can be mechanical parts to be assembled in order to form a mechanical object. Alternatively, the industrial components can be electronic components to be assembled to form an electronic circuit.

As illustrated in Figure 1, the device 1 comprises a display unit 3, an exploded path management unit 5, a memory 7 and a processor 9.

The display unit 3 is configured to provide the user with visual feedback during their interaction with the device 1.

Specifically, the use of an input device causes the display unit 3 to show visual information reflecting the response of the device 1 to this use. For example, the display unit 3 displays the movement of a cursor in response to the displacement of a pointing device. As such, the display unit 3 can be considered as part of the human-machine interface.

The display unit 3 is configured to display the graphical user interface associated with a CAD software or application. In particular, the display unit 3 allows the user to view a 3D scene and shows the updates of the exploded path within the 3D scene.

The display unit 3 is typically a screen. Such a screen is for example a touchscreen, in which case the display unit 3 is both an input and output device.

The exploded path management unit 5 is configured to manage an exploded path within a 3D scene, and specifically to process the line segments of the connected series of at least three line segments for the purposes of manipulating and updating the exploded path.

Specifically, the exploded path management unit 5 is configured to perform at least the three following functions.

The first function is a handle attachment function. The exploded path management unit 5 is configured to attach a handle to any line segment of the exploded path, except the first and last line segments. The handle attached to a line segment allows a user to translate this line segment along a first and a second direction only. The first direction corresponds to the direction of the line segment immediately preceding the line segment to which the handle is attached, while the second direction corresponds to the direction of the line segment immediately following the line segment to which the handle is attached. Advantageously, the exploded path management unit 5 applies the handle attachment function to each line segment of the exploded path, except the first and last line segments.

The second function is a translation function. The exploded path management unit 5 is configured to translate any line segment of the exploded path to which a handle is attached along the first or second direction. More precisely, the exploded path management unit 5 is configured to apply a translation to *N* consecutive line segments, where *N* is a natural number, by applying this translation to each vertex that is an endpoint of at least one of the *N* consecutive line segments. To apply a translation to a single line segment, i.e. *N =* **1,** the exploded path management unit 5 therefore applies this translation to the endpoints of this line segment, i.e. two consecutive vertices. To apply a translation to several consecutive line segments, i.e. *N* > 1, the exploded path management unit 5 applies the translation to the endpoints of these *N* line segments, i.e. *N +* 1 vertices.

Finally, the third function is an addition function. The exploded path management unit 5 is configured to add to the exploded path a line segment aligned with one of the axes of the three-axis system. As explained below, the addition function is used to link the exploded path back to the fixed starting point or the fixed finishing point when, as a result of one or more translations, the exploded path does not extend from the fixed starting point, i.e. the first line segment does not terminate at the fixed starting point, or to the fixed finishing point, i.e. the last line segment does not terminate at the fixed finishing point. In other words, the exploded path management unit 5 is configured to add a *linking* line segment extending from one or the other endpoint of the exploded path to the fixed starting point or the fixed finishing point.

Optionally, the exploded path management unit 5 is further configured to perform a fourth function, which is a deletion function. In such a case, the exploded path management unit 5 is configured to delete a line segment from the exploded path. As explained below, the deletion function is used to delete the first and/or the last line segment.

The operation of the exploded path management unit 5 results, at least for the translation function, the addition function and the deletion function, in visual modifications of the exploded path on the display unit 3. Furthermore, when the handle attachment function is performed, a graphical icon may appear visually next to or on the line segment to which the handle is attached.

The exploded path management unit 5 should be seen as a multifunctional block of a CAD software or application, i.e. a set of instructions whose execution causes the handle attachment, translation, addition, and deletion functions to be selectively performed.

The memory 7 is configured to store a computer program comprising instructions whose execution, by the processor 9, causes the device 1 to update an exploded path within a 3D scene.

The memory 7 can be any computer-readable storage medium capable of receiving and storing data. Such a computer-readable storage medium can a be a transitory or a non-transitory medium. The memory 7 can be a hard disk drive (HDD), a flash memory - such as a solid-state drive (SSD) or a Secure Digital (SD) card -, a random access memory (RAM), an optical disc, a magneto-optical drive, or a solid-state hybrid drive (SSHD), for instance. A combination of several types of computer-readable storage media can also be envisaged.

The processor 9 is configured to execute the instructions stored in the memory 7 for updating an exploded path within a 3D scene. More particularly, the processor 9 is configured to drive the display unit 3 and the exploded path management unit 5 based on the instructions stored in the memory 7.

The processor 9 can be a microprocessor, a programmable logic device (PLD) - such as a field-programmable gate array (FPGA) or a complex programmable logic device (CPLD) -, an application-specific integrated circuit (ASIC), or a microcontroller. A combination of several types of processors can also be envisaged.

A method for updating an exploded path within a 3D scene will now be described hereinafter with reference to Figure 2.

This method is implemented within the context of a CAD software or application, and more precisely when a user uses the CAD software or application to generate or manipulate a 3D scene including at least one 3D model augmented with an exploded path.

In an operation 200, the display unit 3 displays a 3D scene.

For example, the user interacts with the device 1 through an input device to generate or download this 3D scene with the graphical user interface associated with the CAD software or application.

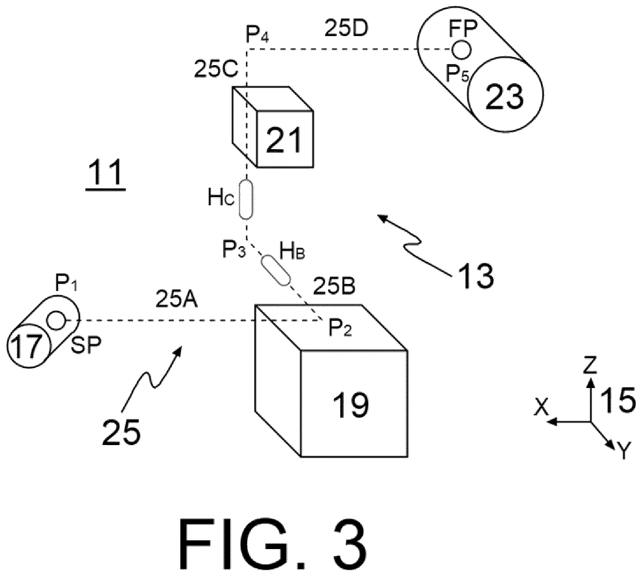

An example of a 3D scene is illustrated in Figure 3. Notwithstanding the reference signs, Figure 3 typically resembles what is displayed by the display unit 3.

Figure 3 shows a 3D scene 11. The 3D scene 11 is a virtual 3D space 13 provided with a three-axis system 15 and containing four 3D models, namely a 3D cylinder model 17, a 3D cube model 19, another 3D cube model 21, and another 3D cylinder model 23.

The three-axis system 15 is an orthogonal basis comprising the X-, Y-, and Z-axes, which are mutually orthogonal. The X-axis, Y-axis, and Z-axis each define a respective direction. For simplicity, each direction will be referred to by the axis that defines it, i.e. the X-direction, the Y-direction, and the Z-direction.

The 3D models 17, 19, 21, and 23 are augmented with an exploded path 25 extending from a fixed starting point SP to a fixed finishing point FP in the virtual 3D space 13. Specifically, the fixed starting point SP is located at the 3D cylinder model 17, while the fixed finishing point FP is located at the 3D cylinder model 23.

For example, the 3D cylinder model 17 corresponds to a real cylinder that must move to another real cylinder to which the 3D cylinder model 23 corresponds. Such a movement can represent an assembly operation of the 3D cylinder model 17 and the 3D cylinder model 23 in order to manufacture a mechanical object.

The exploded path 25 thus exhibits the first characteristic mentioned above.

The exploded path 25 is a connected series of four line segments 25A, 25B, 25C, and 25D.

The exploded path 25 is defined by a sequence of five vertices P₁, P₂, P₃, P₄, and P₅. The line segment 25A is bounded by the vertices P₁ and P₂, the line segment 25B is bounded by the vertices P₂ and P₃, the line segment 25C is bounded by vertices P₃ and P₄, and the line segment 25D is bounded by the vertices P₄ and P₅. The line segment 25A is the first line segment, while the line segment 25D is the last line segment. The first vertex P₁ and the last vertex P₅ are the endpoints of the exploded path 25. In accordance with the first characteristic, the first vertex P₁ has the same position as the fixed starting point SP, while the last vertex P₅ has the same position as the fixed finishing point FP.

The line segments 25A, 25B, 25C, and 25D are all dashed lines.

Each of the line segments 25A, 25B, 25C, and 25D is aligned with one of the axes of the three-axis system 15 according to a periodic direction pattern. Specifically, the line segment 25A is aligned with the X-direction, the line segment 25B is aligned with the Y-direction, the line segment 25C is aligned with the Z-direction, and the line segment 25D is aligned with the X-direction.

The expression "the line segment is aligned with the X-, Y-, or Z-direction" means that the line segment and the X-, Y-, or Z-axis are collinear.

The periodic direction pattern is (X, Y, Z): a line segment aligned with the X-direction must be followed, unless it is the last line segment, by a line segment aligned with the Y-direction; a line segment aligned with the Y-direction must be followed, unless it is the last line segment, by a line segment aligned with the Z-direction; and a line segment aligned with the Z-direction must be followed, unless it is the last line segment, by a line segment aligned with the X-direction.

Equivalently, a line segment aligned with the X-direction must be preceded, unless it is the first line segment, by a line segment aligned with the Z-direction; a line segment aligned with the Y-direction must be preceded, unless it is the first line segment, by a line segment aligned with the X-direction; and a line segment aligned with the Z-direction must be preceded, unless it is the first line segment, by a line segment aligned with the Y-direction

By circular permutation, the periodic direction pattern (X, Y, Z) is equivalent to the periodic direction patterns (Y, Z, X) and (Z, X, Y).

The exploded path 25 thus exhibits the second characteristic mentioned above.

It should be noted that, in absolute terms, three line segments, each aligned along a different direction, are sufficient to connect two points in space, i.e. the fixed starting point SP and the fixed finishing point FP. However, the feature for updating an exploded path within a 3D scene can be used to prevent the exploded path 25 from crossing another exploded path or passing through a 3D model. Therefore, it is preferable to have a connected series of at least four line segments to draw a more flexible exploded path 25.

In an operation 210, the exploded management unit 5 attaches a respective handle to one or more line segments of the exploded path, except the first line segment and last line segments.

In the example of Figure 3, the exploded path management unit 5 applies the handle attachment function to the line segments 25B and 25C. The exploded path management unit 5 therefore attaches a handle H_{B} to the line segment 25B, and attaches a handle H_{C} to the line segment 25C. No handle is attached to the first line segment 25A, and no handle is attached to the last line segment 25D.

The handle H_{B} enables the line segment 25B to translate along a first and a second direction only. The first direction corresponds to the direction of the preceding line segment 25A, i.e. the X-direction. The second direction corresponds to the direction of the following line segment 25C, i.e. the Z-direction.

The handle H_{C} enables the line segment 25C to translate along a first and a second direction only. The first direction corresponds to the direction of the preceding line segment 25B, i.e. the Y-direction. The second direction corresponds to the direction of the following line segment 25D, i.e. the X-direction.

The display unit 3 displays a respective graphical icon on each of the line segments 25B and 25C. The graphical icons visually inform the user that the line segments 25B and 25C are each capable of translating along the first and second directions only. Furthermore, such graphical icons can be selected more easily than the respective line segment to which they are attached, for example with a cursor moved by the user using a pointing device.

The 3D scene 11 depicted in Figure 3 can be updated with the feature according to the invention. In particular, the exploded path 25 exhibits the first and second characteristics, which are preserved by the update, and the line segments 25B and 25C are each provided with a respective handle H_{B} and H_{C}, allowing the user to move them along the first and second directions only.

In an operation 220, the device 1 awaits an instruction to modify the exploded path 25, specifically the application of a translation to a line segment to which a handle is attached, i.e. the line segment 25B or 25C in the example shown in Figure 3.

The device 1 remains on standby in the absence of such an instruction ("KO" in Figure 2).

Typically, such an instruction is detected by the device 1, and more precisely by the processor 9, based on data provided by an input device. In other words, the user uses the input device to select the line segment to be translated.

When the device 1 detects an instruction to apply a translation to a line segment to which a handle is attached ("OK" in Figure 2), it proceeds with the following operations which pertain specifically to the update of the exploded path 25.

In an operation 230, the device 1, and more precisely the processor 9, determines the direction of the translation to be applied to the selected line segment.

The direction of the desired translation can be determined based on the data received from the input device. For example, the user uses a pointing device to point the line segment to be translated - or, where applicable, the associated graphical icon -, and drag it. Such gestures result in the transmission to the processor 9 of spatial data from which the direction of the desired translation is extracted.

Typically, the dragging direction of the cursor is retrieved and compared to the orthogonal projections onto the viewing plane, i.e. the plane onto which the 3D scene 11 is projected, of the first and second directions. In the example developed here, the viewing plane is the plane of Figure 3.

The direction of the desired translation is the one among the first and second directions with which the dragging direction is most collinear.

For example, the processor 9 computes the determinant of the dragging direction and the orthogonal projection onto the viewing plane of the first direction, and computes the determinant of the dragging direction and the orthogonal projection onto the viewing plane of the second direction. The direction of the desired translation is the one for which the corresponding determinant is closest to zero.

The magnitude and sense of the desired translation can also be determined based on the spatial data, specifically according to the magnitude and sense of the movement of the cursor.

Alternatively, the direction of the desired translation can be determined based on the viewing plane only.

To this end, the processor 9 computes a first angle between, on the one hand, the orthogonal projection onto the viewing plane of the direction of the selected line segment and, on the other hand, the orthogonal projection onto the viewing plane of the first direction.

The processor 9 also computes a second angle between, on the one hand, the orthogonal projection onto the viewing plane of the direction of the selected line segment and, on the other hand, the orthogonal projection onto the viewing plane of the second direction.

The direction of the desired translation is the one among the first and second directions for which the angle is closest to a right angle. For example, the processor 9 computes the cosine of the first angle and the cosine of the second angle, and the direction of the desired translation is the one for which the corresponding angle has the cosine closest to zero.

This way of selecting the first or second direction relies on the visibility, on the display unit 3, of the plane defined by the direction of the selected line segment and the first or the second direction. It is more practical and intuitive for the user to apply and view a translation along the most visible direction, i.e. the direction that defines with the direction of the selected line segment the plane having the largest apparent area.

In an operation 240, the exploded path management unit 5 applies the desired translation to the selected line segment and either the following line segment or the preceding line segment.

In particular, the exploded path management unit 5 applies the desired translation to both the selected line segment and the following line segment when the direction of the translation is the first direction. Conversely, the exploded path management unit 5 applies the translation to both the selected line segment and the preceding line segment when the direction of the translation is the second direction.

The operation 240 modifies the exploded path while preserving the second characteristic, as highlighted in the example developed below.

With reference to the example in Figure 3, it is assumed hereinafter that the selected line segment, i.e. the line segment to be translated, is the line segment 25C to which the handle H_{C} is attached. As explained above, the first direction along which the line segment 25C is able to translate is the direction of the preceding line segment 25B, i.e. the Y-direction, while the second direction along which the line segment 25C is able to translate is the direction of the following line segment 25D, i.e. the X-direction.

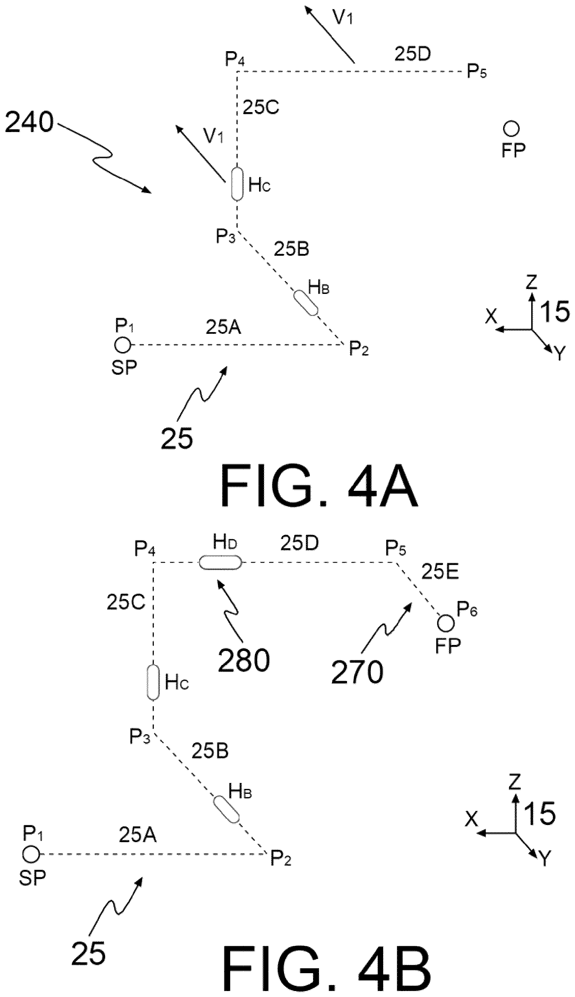

Figures 4A and 4B illustrate the case where the direction of the desired translation is the first direction.

The 3D models 17, 19, 21 and 23 are omitted in Figures 4A and 4B to focus only on the information related to the desired translation along the first direction.

With reference to Figure 4A, the exploded path management unit 5 applies, in the operation 240, the translation function to two consecutive line segments, i.e. *N* = 2 in accordance with the formalism of the translation function detailed above: the selected line segment 25C and the following line segment 25D. As shown in Figure 4A, the desired translation takes the form of a vector V₁. Consequently, the exploded path management unit 5 applies the translation V₁ to each vertex that is an endpoint of at least one of the line segments 25C and 25D, i.e. the vertices P₃, P₄ and P₅.

The application of the translation V₁ to the line segment 25C results in the preceding line segment 25B being stretched. Indeed, only the endpoint P₃ of the line segment 25B is translated, while the other endpoint P₂ remains stationary, and the direction of the translation V₁ is the direction of the line segment 25B.

Consequently, the direction of the line segment 25B remains unchanged, and the respective direction of the preceding line segments, i.e. the line segment 25A in the example of Figure 4A, also remains unchanged.

The translation function relies on the periodic direction pattern, i.e. the periodic direction pattern (X, Y, Z) in the example of Figure 3, to ensure that the modifications to the exploded path 25 remain local and preserves the periodic direction pattern. In the present case, the line segments 25C and 25D are translated, while the line segment 25B is stretched, and no additional modifications would be required even if the exploded path 25 included other line segments preceding the line segment 25A.

The translation function of the exploded path management unit 5 thus provides predictability for the user by preserving the periodic direction pattern and ensuring that the exploded path 25 is not disrupted to the point of moving out of the user's visual field, and more particularly the area of the display unit 3 on which the user is focusing their attention.

In an operation 250, the exploded path management unit 5 determines whether the exploded path 25 still extends from the fixed starting point SP to the fixed finishing FP.

To this end, the exploded path management unit 5 can compare the positions of the endpoints of the exploded path 25 with the positions of the fixed starting point SP and the fixed finishing point FP.

When this is the case ("OK" in Figure 2), the method ends in an operation 260.

However, when the direction of the desired translation is the first direction, the line segment that follows the selected line segment is translated. It therefore may occur that the exploded path 25 no longer extends to the fixed finishing point FP. This situation arises when the following line segment is the last line segment.

In the example of Figure 4A, the direction of the translation V₁ is the first direction. As explained above, the line segment that follows the selected line segment, i.e. the line segment 25D, is thus translated. Yet, the line segment 25D is the last line segment of the exploded path 25. Consequently, the exploded path 25 is no longer linked to the fixed finishing point FP since the vertex P₅ no longer coincides with the fixed finishing point FP after being translated. In other words, the line segment 25D does not terminate at the fixed finishing point FP.

The method therefore continues ("KO" in Figure 2) with an operation 270.

In the operation 270, the exploded path management unit 5 adds a linking line segment to link the exploded path 25 back to the fixed starting point SP or the fixed finishing point FP. The linking line segment is the new first or last line segment of the exploded path 25.

The direction and length of the linking line segment respectively correspond to the direction and magnitude of the translation applied in the operation 240.

The operation 270 restores the first characteristic of the exploded path 25.

In the example of Figure 4B, the exploded path management unit 5 applies the addition function to the exploded path 25. In other words, the exploded path management unit 5 adds to the connected series of line segments a linking line segment 25E extending from the endpoint P₅ of the exploded path 25 to the fixed finishing point FP. To this end, the exploded path management unit 5 adds a new vertex P₆ that coincides with the fixed finishing point FP, with the linking line segment 25E being bounded by the vertices P₅ and P₆. The vertex P₆ is the new endpoint of the exploded path 25. Since the direction of the translation V₁ applied to the vertex P₅ is the first direction, the linking line segment 25E is aligned with the first direction, i.e. the Y-direction.

The addition function of the exploded path management unit 5 preserves the periodic direction pattern and thus provides predictability. In particular, as illustrated in Figure 4B, the line segment 25D aligned with the X-direction is followed by the line segment 25E aligned with the Y-direction in accordance with the periodic direction pattern (X, Y, Z).

In the example of Figure 2, the operations 240 and 270 are implemented sequentially. However, advantageously, the operations 240 and 270 are implemented simultaneously. Specifically, the user moves the line segment 25C using the input device, and the display unit 3 shows the translation of both the line segments 25C and 25D, as well as the line segment 25E stretching or contracting in real time in response to the translation of the line segment 25C.

Optionally, in an operation 280, the exploded path management unit 5 attaches a handle to the line segment that is connected to the linking line segment.

It should be understood from the above that the line segment connected to the linking line segment was, prior to the addition of the linking line segment, either the first or the last line segment of the exploded path 25.

When the direction of the desired translation is the first direction, the linking line segment is added if the line segment that follows the selected line segment is the last line segment. In this case, the linking line segment becomes the last line segment, and the line segment following the selected line segment is now followed by the linking line segment. Consequently, a second direction, and not just a first direction, can be determined for the line segment following the selected line segment. Accordingly, the exploded path management unit 5 can attach a handle to the line segment following the selected line segment.

In the example of Figure 4B, the exploded path management unit 5 attaches a handle H_{D} to the line segment 25D. Furthermore, the display unit 3 displays a graphical icon on the line segment 25D.

The handle H_{D} enables the line segment 25D to translate along a first and a second direction only. The first direction corresponds to the direction of the preceding line segment 25C, i.e. the Z-direction. The second direction corresponds to the direction of the following line segment 25E, i.e. the Y-direction.

When the direction of the desired translation is the second direction, the linking line segment is added if the line segment that precedes the selected line segment is the first line segment. In this case, the linking line segment becomes the first line segment, and the line segment preceding the selected line segment is now preceded by the linking line segment. Consequently, a first direction, and not just a second direction, can be determined for the line segment preceding the selected line segment. Accordingly, the exploded path management unit 5 can attach a handle to the line segment preceding the selected line segment.

Finally, the method ends in the operation 260.

Figures 4A and 4B discussed so far illustrate the part of the method starting from the operation 240 in the case where the direction of the desired translation is the first direction.

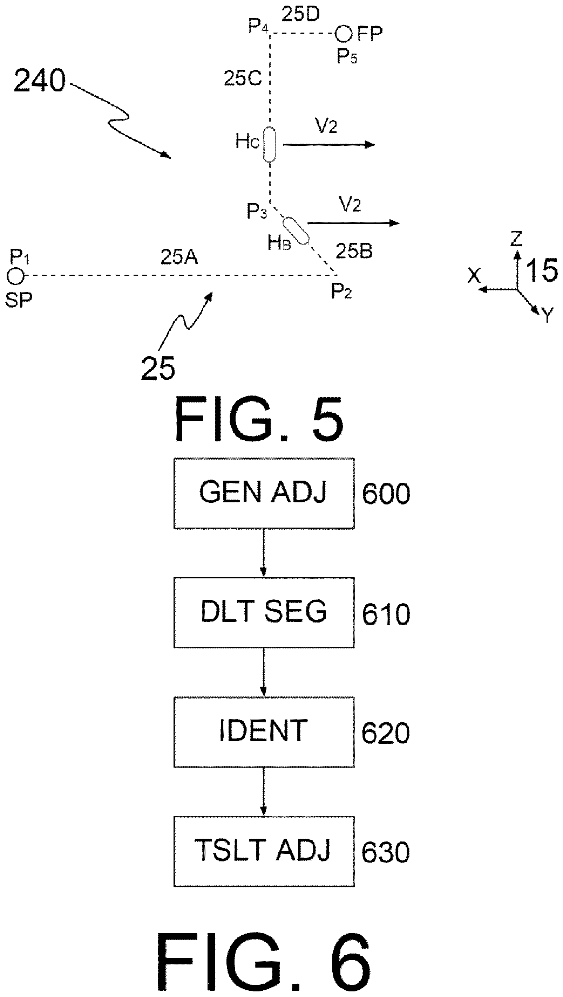

Reference is now made to Figure 5, which illustrates the case where the direction of the desired translation is the second direction.

The 3D models 17, 19, 21 and 23 are omitted in Figure 5 to focus only on the information related to the desired translation along the second direction.

With reference to Figure 5, the exploded path management unit 5 applies, in the operation 240, the translation function to two consecutive line segments, i.e. *N* = 2 in accordance with the formalism of the translation function detailed above: the selected line segment 25C and the preceding line segment 25B. As shown in Figure 5, the desired translation takes the form of a vector V₂. Consequently, the exploded path management unit 5 applies the translation V₂ to each vertex that is an endpoint of at least one of the line segments 25B and 25C, i.e. the vertices P₂, P₃ and P₄.

The application of the translation V₂ to the line segment 25B results in the preceding line segment 25A being stretched. Indeed, only the endpoint P₂ of the line segment 25A is translated, while the other endpoint P₁ remains stationary, and the direction of the translation V₂ is the direction of the line segment 25A.

Consequently, the direction of the line segment 25A remains unchanged.

The application of the translation V₂ to the line segment 25C results in the following line segment 25D being contracted. Indeed, only the endpoint P₄ of the line segment 25D is translated, while the other endpoint P₅ remains stationary, and the direction of the translation V₂ is the direction of the line segment 25D.

Consequently, the direction of the line segment 25D remains unchanged.

As explained above in the example of Figure 4A where the direction of the desired translation is the first direction, the translation function relies on the periodic direction pattern, i.e. the periodic direction pattern (X, Y, Z) in the example of Figure 3, to ensure that the modifications to the exploded path 25 remain local and preserves the periodic direction pattern. In the present case, the line segments 25B and 25C are translated, while the line segment 25A is stretched and the line segment 25D is contracted, and no additional modifications would be required even if the exploded path 25 included other line segments preceding the line segment 25A and/or following the line segment 25D.

In the operation 250, the exploded path management unit 5 determines whether the exploded path 25 still extends from the fixed starting point SP to the fixed finishing FP.

When the direction of the desired translation is the second direction, the line segment that precedes the selected line segment is translated. It therefore may occur that the exploded path 25 no longer extends from the fixed starting point SP. This situation arises when the preceding line segment is the first line segment.

In the example of Figure 5, the direction of the translation V₂ is the second direction. As explained above, the line segment that precedes the selected line segment, i.e. the line segment 25B, is thus translated. Yet, the line segment 25B is not the first line segment of the exploded path 25. Consequently, the exploded path 25 is still linked to the fixed starting point SP. In particular, the vertex P₁ still coincides with the fixed starting point SP. In other words, the line segment 25A terminates at the fixed starting point SP.

In the present case, the method thus directly ends in the operation 260 ("OK" in Figure 2).

The skilled person understands, thanks to the example of Figure 4B, how the operation 270, and optionally the operation 280, would have been implemented in the case of Figure 5 if the line segment 25B had been the first line segment.

In a nutshell, the exploded path management unit 5 would have added to the connected series of line segments a linking line segment extending from the fixed starting point SP to the vertex P₂. To this end, the exploded path management unit 5 would have added a vertex coinciding with the fixed starting point SP, with the linking line segment being bounded by this added vertex and the vertex P₂. This added vertex would have been the new endpoint of the exploded path 25.

In view of the foregoing, it is clear that updating the exploded path 25 preserves its first and second characteristics. The preservation of the first characteristic ensures that the exploded path 25 still links the same points, i.e. the fixed starting point SP and the fixed finishing point FP. The preservation of the second characteristic ensures the predictability of the update to the exploded path 25, particularly that the translation of a line segment does not disrupt the exploded path 25 to the extent that the user visually loses track of the updated exploded path 25.

The method of Figure 2 allows the user to modify the exploded path 25 efficiently, accurately, and without wasting time. Specifically, the feature for updating an exploded path within a 3D scene according to the method of Figure 2 reduces the time and computational resources required for the interaction between the input device and the device 1.

The feature for updating an exploded path within a 3D scene described above eases the design of an industrial product, for example a mechanical object or an electronic circuit, or the manufacture of such an industrial product by providing a clear and comprehensible assembly diagram.

The invention typically falls within the broader context of the manufacturing or assembly of an industrial product, where the method of Figure 2 is followed by a manufacturing or assembly operation of an industrial product comprising one or more industrial components - each represented by a respective 3D industrial component model within the virtual 3D space 13 - according to the exploded path 25.

Figure 6 illustrates optional operations of the method shown in Figure 2. These optional operations are implemented in response to an instruction to delete the first or the last line segment of the exploded path 25.

Typically, such an instruction is detected by the device 1, and more precisely by the processor 9, based on data provided by an input device. In other words, the user uses the input device to select the line segment to be deleted.

In an operation 600, the processor 9 generates an *adjustment* translation.

As explained below, the adjustment translation will be used, after the selected line segment is deleted, to preserve the first characteristic of the exploded path. The direction, amplitude and sense of the adjustment translation are all selected for this purpose.

In particular, the direction of the adjustment translation is the direction of the selected line segment, while the magnitude of the adjustment translation is the length of the selected line segment.

With reference to Figure 3, it is assumed hereinafter that the selected line segment is the line segment 25D, i.e. the last line segment of the exploded path 25.

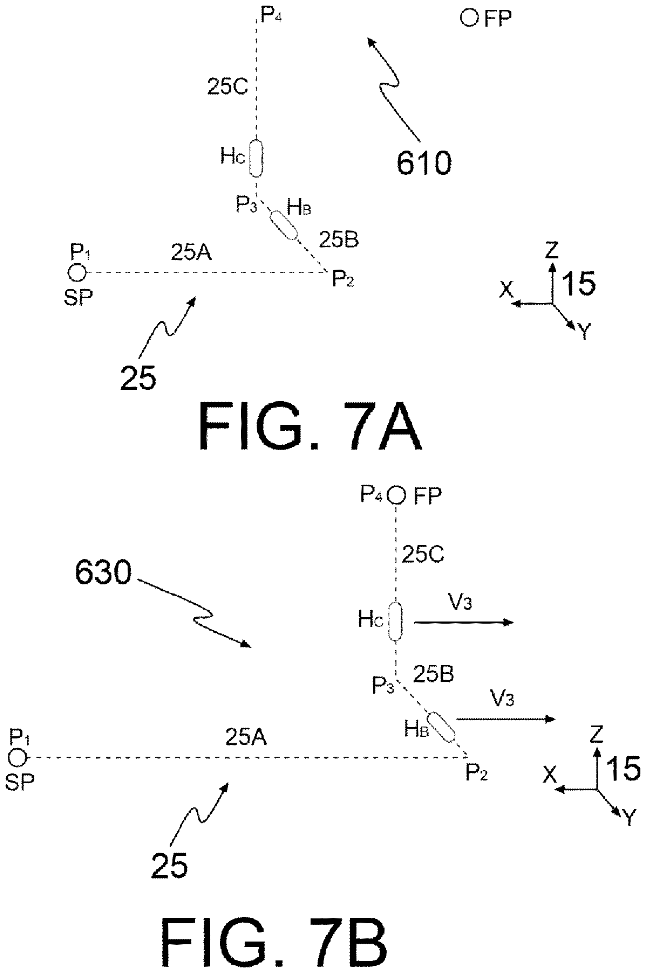

Figures 7A and 7B illustrate the deletion from the exploded path 25 of the line segment 25D.

The 3D models 17, 19, 21 and 23 are omitted in Figures 7A and 7B to focus only on the information related to the deletion of the line segment 25D.

In an operation 610, the exploded path management unit 5 deletes the selected line segment.

With reference to Figure 7A, the exploded path management unit 5 applies the deletion function to the line segment 25D. Consequently, as shown in Figure 7A, the line segment 25D is now absent from the exploded path 25.

The deletion of the line segment 25D results in the exploded path 25 no longer extending to the fixed finishing point FP, which is logical since the line segment 25D was the last line segment of the exploded path 25, i.e. the one that terminated at the fixed finishing point FP before being deleted.

In an operation 620, the processor 9 identifies a line segment whose direction is the same as that of the deleted line segment. It should be noted that any line segment aligned with the direction of the deleted line segment is suitable.

In the example of Figure 7A, the processor 9 necessarily identifies the line segment 25A. Indeed, the deleted line segment 25D was aligned with the X-direction, and the line segment 25A is the only other line segment of the exploded path 25 aligned with the X-direction.

Finally, in an operation 630, the exploded path management unit 5 applies the adjustment translation to all the line segments of the exploded path that either precede or follow the identified line segment in order to link the exploded path back to the fixed starting point SP or the fixed finishing point FP.

More particularly, the exploded path management unit 5 applies the adjustment translation to all the line segments that precede the identified line segment when the deleted line segment was the first line segment. Conversely, the exploded path management unit 5 applies the adjustment translation to all the line segments that follow the identified line segment when the deleted line segment was the last line segment.

With reference to Figure 7B, the exploded path management unit 5 applies, in the operation 630, the translation function to two consecutive line segments, i.e. *N* = 2 in accordance with the formalism of the translation function detailed above: the following line segments 25B and 25C. As shown in Figure 7B, the adjustment translation takes the form of a vector V₃. Consequently, the exploded path management unit 5 applies the translation V₃ to each vertex that is an endpoint of at least one of the line segments 25B and 25C, i.e. the vertices P₂, P₃ and P₄.

The application of the translation V₃ to the line segment 25B results in the preceding line segment 25A being stretched. Indeed, only the endpoint P₂ of the line segment 25A is translated, while the other endpoint P₁ remains stationary, and the direction of the translation V₃ is the direction of the line segment 25A.

Moreover, and most importantly, the application of the translation V₃ to the line segment 25C results in the line segment 25C now terminating at the fixed finishing point FP. In other words, the vertex P₄ now coincides with the fixed finishing point FP. The exploded path 25 therefore extends to the fixed finishing point FP, and the first characteristic of the exploded path 25 is preserved.

## Claims

1. A computer-implemented method for updating an exploded path (25) within a 3D scene (11), comprising the following operations:
a) displaying (200) a 3D scene (11), said 3D scene (11) being a virtual 3D space (13) provided with a three-axis system (15) and containing at least one 3D model (17, 19, 21, 23), a fixed starting point (SP) and a fixed finishing point (FP), said at least one 3D model (17, 19, 21, 23) being augmented with an exploded path (25) extending from said fixed starting point (SP) to said fixed finishing point (FP), said exploded path (25) being a connected series of at least three line segments (25A, 25B, 25C, 25D) each aligned with one of the axes (X, Y, Z) of said three-axis system (15) according to a periodic direction pattern;
b) attaching (210) a respective handle (H_{B}, H_{C}) to one or more line segments (25B, 25C) of the connected series of at least three line segments (25A, 25B, 25C, 25D), except the first and last line segments (25A, 25D), each handle (H_{B}, H_{C}) enabling the line segment (25B, 25C) to which it is attached to translate along a first and a second direction only, said first direction corresponding to the direction of the preceding line segment, said second direction corresponding to the direction of the following line segment;
said computer-implemented method further comprising, upon instruction to apply a given translation to a given line segment (25C) to which a given handle (H_{C}) is attached:
c) applying (240) said given translation to both said given line segment (25C) and either the following line segment (25D) when the direction of the given translation is the first direction, or the preceding line segment (25B) when the direction of the given translation is the second direction, thereby preserving the periodic direction pattern; and, if the exploded path (25) no longer extends from the fixed starting point (SP) or to the fixed finishing point (FP) as a result of operation c),
d) adding (270) to the connected series of at least three line segments (25A, 25B, 25C, 25D) a linking line segment (25E) aligned with the direction of the given translation to relink the exploded path (25) to the fixed starting point (SP) or the fixed finishing point (FP).

2. The computer-implemented method according to claim 1, wherein, in operation b), a respective handle (H_{B}, H_{C}) is attached (210) to each line segment (25B, 25C) of the connected series of at least three line segments (25A, 25B, 25C, 25D), except the first and last line segments (25A, 25D).

3. The computer-implemented method according to claim 1 or 2, wherein operation d) includes attaching (280) a handle (H_{D}) to the line segment (25D) that, among the preceding line segment (25B) and the following line segment (25D), is connected to the linking line segment (25E).

4. The computer-implemented method according to one of the preceding claims, wherein, in operation b), attaching (210) a respective handle (H_{B}, H_{C}) to one or more line segments (25B, 25C) of the connected series of at least three line segments (25A, 25B, 25C, 25D) results in the display of a respective graphical icon next to or on said one or more line segments (25B, 25C).

5. The computer-implemented method according to one of the preceding claims, wherein the instruction to apply the given translation to the given line segment (25C) to which the given handle (H_{C}) is attached is detected based on data received from an input device.

6. The computer-implemented method according to claim 5, wherein the direction of the given translation is determined (230) based on said data.

7. The computer-implemented method according to one of claims 1 to 5, wherein, in operation a), the 3D scene (11) is projected onto a viewing plane, and the direction of the given translation is determined (230) as follows:
computing a first angle between the orthogonal projections onto said viewing plane of the direction of the given line segment (25C) and the first direction,
computing a second angle between the orthogonal projections onto said viewing plane of the direction of the given line segment (25C) and the second direction, and
selecting the first direction if the first angle is closer to a right angle than the second angle, or the second direction if the second angle is closer to a right angle than the first angle.

8. The computer-implemented method according to one of the preceding claims, wherein the connected series of at least three line segments (25A, 25B, 25C, 25D) is a connected series of at least four line segments (25A, 25B, 25C, 25D).

9. The computer-implemented method according to claim 8, further comprising, upon instruction to delete the first line segment (25A) or the last line segment (25D) from the connected series of at least four line segments (25A, 25B, 25C, 25D):
e) generating (600) an adjustment translation whose direction and magnitude are respectively the direction and the length of the line segment to be deleted;
f) deleting (610) the line segment (25D) to be deleted;
g) identifying (620), within the connected series of at least four line segments (25A, 25B, 25C, 25D), a line segment (25A) aligned with the direction of the deleted line segment (25D); and
h) applying (630) the adjustment translation to all the line segments (25B, 25C) of the connected series of at least four line segments (25A, 25B, 25C, 25D) that either precede said identified line segment (25A) when the deleted line segment (25D) was the first line segment (25A), or follow said identified line segment (25A) when the deleted line segment (25D) was the last line segment (25D) to relink the exploded path (25) to the fixed starting point (SP) or the fixed finishing point (FP).

10. The computer-implemented method according to one of the preceding claims, each line segment (25A, 25B, 25C, 25D) of the connected series of at least three line segments (25A, 25B, 25C, 25D) being bounded by two endpoints (P₁, P₂, P₃, P₄, P₅), wherein the application of any translation to any consecutive line segments of the connected series of at least three line segments (25A, 25B, 25C, 25D) is performed by applying said translation to each endpoint of at least one line segment of said consecutive line segments.

11. The computer-implemented method according to one of the preceding claims, wherein each line segment (25A, 25B, 25C, 25D) of the connected series of at least three line segments (25A, 25B, 25C, 25D) is a dashed line, a dotted line or a dash-dotted line.

12. The computer-implemented method according to one of the preceding claims, wherein the 3D scene (11) is an assembly diagram, the at least one 3D model (17, 19, 21, 23) includes a first 3D industrial component model (17) and a second 3D industrial component model (23) positioned at the fixed starting point (SP) and the fixed finishing point (FP), respectively, the first and second 3D industrial component models (17, 23) respectively corresponding to first and second real industrial components intended to be assembled together.

13. A computer program comprising instructions for implementing the computer-implemented method according to one of the preceding claims when said instructions are executed by at least one processor (9).

14. A computer-readable storage medium (7) having stored thereon the computer program of claim 13.

15. A device (1) for updating an exploded path (25) within a 3D scene (11), comprising:
• a display unit (3) configured to display a 3D scene (11), said 3D scene (11) being a virtual 3D space (13) provided with a three-axis system (15) and containing at least one 3D model (17, 19, 21, 23), a fixed starting point (SP) and a fixed finishing point (FP), said at least one 3D model (17, 19, 21, 23) being augmented with an exploded path (25) extending from said fixed starting point (SP) to said fixed finishing point (FP), said exploded path (25) being a connected series of at least three line segments (25A, 25B, 25C, 25D) each aligned with one of the axes (X, Y, Z) of said three-axis system (15) according to a periodic direction pattern;
• an exploded path management unit (5) configured to
- attach a handle (H_{B}, H_{C}) to any line segment (25B, 25C) of the connected series of at least three line segments (25A, 25B, 25C, 25D), except the first and last line segments (25A, 25D), said handle (H_{B}, H_{C}) enabling the line segment (25B, 25C) to which it is attached to translate along a first and a second direction only, said first direction corresponding to the direction of the preceding line segment, said second direction corresponding to the direction of the following line segment,
- apply to any line segment (25B, 25C) to which a handle (H_{B}, H_{C}) is attached any translation whose direction is the first or second direction, and
- add to the connected series of at least three line segments (25A, 25B, 25C, 25D) a line segment (25E) aligned with one of the axes (X, Y, Z) of the three-axis system (15); and
• a processor (9) configured, upon instruction to apply a given translation to a given line segment (25C) to which a given handle (H_{C}) is attached, to cause the exploded path management unit (5) to
- apply said given translation to both said given line segment (25C) and either the following line segment (25D) when the direction of the given translation is the first direction, or the preceding line segment (25B) when the direction of the given translation is the second direction, thereby preserving the periodic direction pattern, and, if the exploded path (25) no longer extends from the fixed starting point (SP) or to the fixed finishing point (FP) as a result of the application of the given translation,
- add a linking line segment (25E) aligned with the direction of the given translation to relink the exploded path (25) to the fixed starting point (SP) or the fixed finishing point (FP).
